# EUROPEAN PATENT SPECIFICATION

(11) **EP 2 255 602 B1**
(45) Date of publication and mention of the grant of the patent: **25.01.2012**
(21) Application number: 09722908.2
(22) Date of filing: 17.03.2009
(51) Int. Cl.: H05K 3/00

(54) **IMAGING SYSTEM AND METHOD FOR ALIGNMENT**
ABBILDUNGSSYSTEM UND -VERFAHREN FÜR AUSRICHTUNGSZWECKE
SYSTÈME D'IMAGERIE ET PROCÉDÉ D'ALIGNEMENT

(30) Priority: 17.03.2008 GB 0804941
(43) Date of publication of application: 01.12.2010
(73) Proprietor: DTG International GmbH, 8005 Zürich (CH)
(72) Inventor: BUTTLE, Martyn, Weymouth Dorset DT4 9TH (GB); SYMONS, Martin, Weymouth Dorset DT4 9TH (GB)
(74) Representative: Boden, Keith McMurray
(86) International application number: PCT/GB2009/000722
(87) International publication number: WO 2009/115796

(56) References cited:
- EP-A2- 1 786 247
- WO-A2-02/097534
- DE-A1- 4 416 882
- GB-A- 2 249 672
- GB-A- 2 351 258
- JP-A- 2002 361 464
- US-A1- 2002 109 775
- US-A1- 2006 048 383
- US-A1- 2008 044 059
- US-B1- 6 193 899

## Description

The present invention relates to an imaging system for and a method of imaging a workpiece, in particular a printed circuit board, in order to provide for alignment of the workpiece to a printing screen, often alternatively referred to as a printing stencil.

Screen printing machines are extensively used for depositing print media, such as solder pastes and adhesives, on printed circuit boards in the manufacture of electronic circuit boards.

In printing on printed circuit boards, it is necessary to align the printing screen to the printed circuit board in order to ensure that deposits of print medium are printed on the printed circuit board at the required positions.

Currently, in aligning the printing screen to a printed circuit board, one or more video cameras are introduced between the printed circuit board and the printing screen to image one or more alignment features on the printed circuit board and the printing screen, and the acquired images are processed using image processing software to determine the misalignment and required positional correction of the printed circuit board and the printing screen.

In order to achieve the required accuracy, alignment features are imaged at two or more widely-spaced positions on the printed circuit board and the printing screen.

In requiring one or more video cameras to be introduced between the printed circuit board and the printing screen, there is a time penalty in introducing the one or more video cameras and withdrawing the same after acquiring the images, and also with closing the gap between the printed circuit board and the printing screen, which gap is necessary to allow for the introduction of the one or more video cameras.

Further, where a single video camera is used, there is a time penalty associated with moving the video camera between each of the imaging positions, in acquiring each of the images.

These time factors add directly to the cycle time of the screen printing machine, and therefore reduce the throughput of the machine.

JP-A-2002/361464 discloses a method and device for laser beam machining, in which a positioning mark is read out with a CCD camera which is sensitive to the wavelength of light emitted from a lighting device.

US-A-2008/0044059 discloses a micromachining apparatus and method, in which the position of a site to be machined is determined by illuminating the site with illumination at an illumination wavelength and forming an image from the returning radiation.

EP-A-1786247 discloses a method of manufacturing a wired circuit board, which utilises reflection-type optical sensors to detect a defective shape of the conductive pattern and in mounting electronic components.

It is an aim of the present invention to provide an imaging system for and a method of imaging workpieces which avoids the need to introduce an imaging unit, such as a video camera, between the workpiece and a printing screen.

In one aspect the present invention provides an imaging system for imaging at least one workpiece alignment feature on an upper surface of a supported workpiece, the system comprising: a workpiece support which includes a support surface for supporting a workpiece; and at least one imaging unit which is disposed below the support surface of the workpiece support for imaging at least one workpiece alignment feature on the upper surface of the workpiece, wherein the at least one imaging unit comprises an infra-red illuminator which is operative to illuminate a region of a lower surface of the workpiece and a detector which is operative to capture an image of the region of the workpiece which includes at least one workpiece alignment feature on the upper surface of the workpiece.

In one embodiment the infra-red illuminator is a near infra-red illuminator.

In one embodiment the infra-red illuminator provides illumination at a wavelength in the range of about 760 nm to about 1000 nm.

In one embodiment the infra-red illuminator provides illumination at a wavelength of about 880 nm.

In one embodiment the system comprises: first and second imaging units for imaging first and second workpiece alignment features on the upper surface of the workpiece.

In one embodiment the imaging units comprise camera units and the detector comprises a camera.

In one embodiment the illuminator of each imaging unit is operative to illuminate both a region of a lower surface of the workpiece and a region of a lower surface of a printing screen which is disposed above the workpiece support, and the detector of each imaging unit is operative to capture both an image of the region of the workpiece which includes at least one workpiece alignment feature on the upper surface of the workpiece and an image of the region of the printing screen which includes at least one screen alignment feature.

In another embodiment the illuminator of each imaging unit is operative to illuminate a region of a lower surface of a printing screen which is disposed above the workpiece support when no workpiece is supported on the workpiece support and illuminate a region of a lower surface of the workpiece when supported on the workpiece support, and the detector of each imaging unit is operative to capture an image of the region of the printing screen which includes at least one screen alignment feature when no workpiece is supported on the workpiece support and capture an image of the region of the workpiece which includes at least one workpiece alignment feature on the upper surface of the workpiece when supported on the workpiece support.

In a further embodiment the system further comprises: at least one further imaging unit for imaging at least one screen alignment feature on a printing screen which is disposed above the workpiece support, wherein the at least one further imaging unit comprises an illuminator which is operative to illuminate a region of a lower surface of the printing screen and a detector which is operative to capture an image of the region of the printing screen which includes at least one screen alignment feature.

In one embodiment the system comprises: first and second further imaging units for imaging first and second screen alignment features on the printing screen.

In another aspect the present invention provides a screen printing machine, comprising: the above-described imaging system.

In a further aspect the present invention provides a screen printing machine, comprising: the above-described imaging system; an image processor for determining a required positional correction of the workpiece and the printing screen from the imaged alignment features; and a positioner for performing the required positional correction of the workpiece and the printing screen.

In a still further aspect the present invention provides a method of imaging at least one workpiece alignment feature on an upper surface of a supported workpiece, the method comprising the steps of: supporting a workpiece on a support surface of a workpiece support; and imaging at least one workpiece alignment feature on the upper surface of the workpiece from below the support surface of the workpiece support, wherein the imaging step comprises the steps of: illuminating a region of a lower surface of the workpiece with infra-red illumination; and capturing an image of the region of the workpiece which includes at least one workpiece alignment feature on the upper surface of the workpiece.

In one embodiment the infra-red illumination is near infra-red illumination.

In one embodiment the infra-red illumination has a wavelength in the range of about 760 nm to about 1000 nm.

In one embodiment the infra-red illumination has a wavelength of about 880 nm.

In one embodiment, in the imaging step, first and second workpiece alignment features are imaged on the upper surface of the workpiece, and the imaging step comprises the steps of: illuminating first and second regions of a lower surface of the workpiece with infra-red illumination; and capturing first and second images of the regions of the workpiece which include respective ones of first and second workpiece alignment features on the upper surface of the workpiece.

In another embodiment a printing screen is disposed above the workpiece support and at least one screen alignment feature on the printing screen is further imaged in the imaging step, and the imaging step comprises the steps of: illuminating both a region of a lower surface of the workpiece and a region of a lower surface of the printing screen with an illuminator, wherein the lower surface of the workpiece is illuminated with infra-red illumination; and capturing both an image of the region of the workpiece which includes at least one workpiece alignment feature on the upper surface of the workpiece and an image of the region of the printing screen which includes at least one screen alignment feature with a detector.

In a further embodiment a printing screen is disposed above the workpiece support and at least one screen alignment feature on the printing screen is further imaged in the imaging step, and the imaging step comprises the steps of: illuminating a region of a lower surface of the printing screen when no workpiece is supported on the workpiece support; capturing an image of the region of the printing screen which includes at least one screen alignment feature; supporting a workpiece on the workpiece support; illuminating a region of a lower surface of the workpiece with infra-red illumination; and capturing an image of the region of the workpiece which includes at least one workpiece alignment feature.

In a yet further embodiment a printing screen is disposed above the workpiece support and, in the imaging step, first and second workpiece alignment features are imaged on the upper surface of the workpiece and first and second screen alignment features are imaged on the printing screen, and the imaging step comprises the steps of: illuminating first regions of a lower surface of the workpiece and a lower surface of the printing screen with a first illuminator, and second regions of the lower surface of the workpiece and the lower surface of the printing screen with a second illuminator, wherein the regions of the lower surface of the workpiece are illuminated with infra-red illumination; and capturing first images of the first region of the workpiece which includes at least one workpiece alignment feature on the upper surface of the workpiece and the first region of the printing screen which includes at least one screen alignment feature using a first detector, and second images of the second region of the workpiece which includes at least one workpiece alignment feature on the upper surface of the workpiece and the second region of the printing screen which includes at least one screen alignment feature using a second detector.

In a still yet further embodiment a printing screen is disposed above the workpiece support and, in the imaging step, first and second workpiece alignment features are imaged on the upper surface of the workpiece and first and second screen alignment features are imaged on a printing screen, and the imaging step comprises the steps of: illuminating first and second regions of a lower surface of the workpiece with respective ones of first and second illuminators, which are infra-red illuminators; illuminating first and second regions of a lower surface of the printing screen with respective ones of third and fourth illuminators; capturing first and second images of the first and second regions of the workpiece which include respective ones of first and second workpiece alignment features on the upper surface of the workpiece using respective ones of first and second detectors; and capturing first and second images of the first and second regions of the printing screen which include respective ones of first and second screen alignment features using respective ones of third and fourth detectors.

In a yet further aspect the present invention provides a method of screen printing on workpieces, the method comprising the steps of: imaging at least one workpiece alignment feature on an upper surface of a supported workpiece using the above-described imaging method.

In a still yet further aspect the present invention provides a method of screen printing on workpieces, the method comprising the steps of: imaging at least one workpiece alignment feature on an upper surface of a supported workpiece and at least one screen alignment feature on the printing screen using the above-described imaging method; determining a required positional correction of the workpiece and the printing screen from the imaged alignment features; and performing the required positional correction of the workpiece and the printing screen.

A preferred embodiment of the present invention will now be described hereinbelow by way of example only with reference to the accompanying drawings, in which:

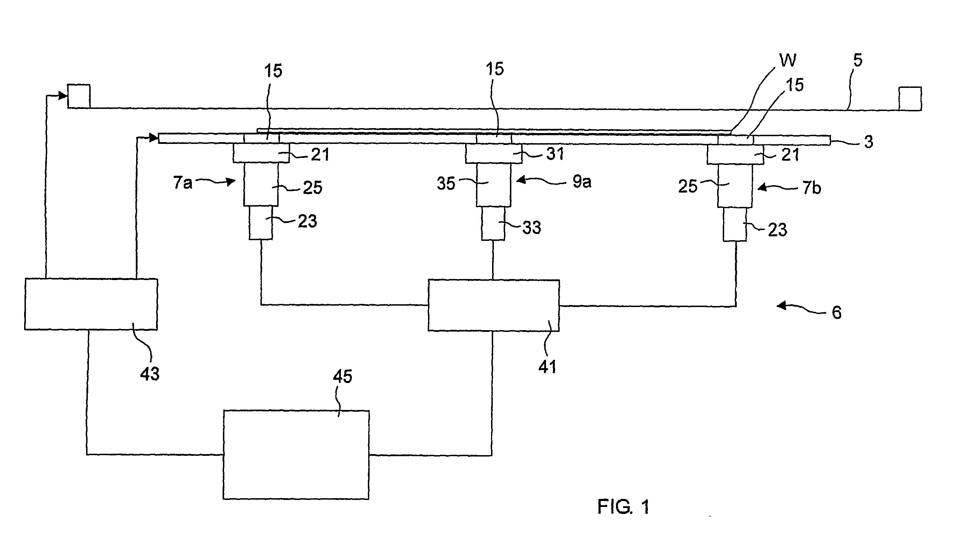

Figure 1 illustrates a side elevational view of a screen printing machine incorporating an imaging system in accordance with a preferred embodiment of the present invention;

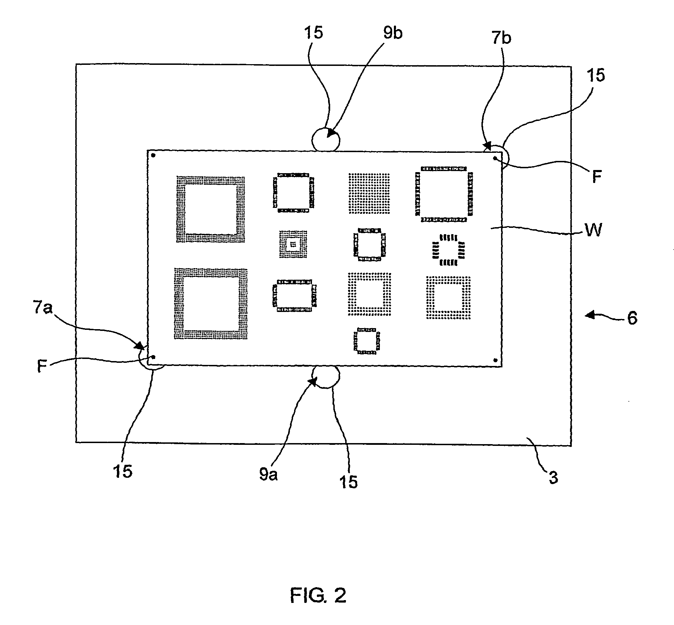

Figure 2 illustrates a plan view of the imaging system of Figure 1;
Figure 3 illustrates an image acquired from the lower surface of a workpiece using the imaging system of Figure 1; and
Figure 4 illustrates a counterpart image to Figure 3, but where acquired using visible light as the illumination source.

The screen printing machine comprises a workpiece support 3, in this embodiment a flat plate, for supporting a workpiece W, in this embodiment a printed circuit board, a printing screen 5 which is disposed above the workpiece support 3 for printing a pattern of deposits of a print medium, such as a solder paste or adhesive, onto the supported workpiece W, and an imaging system 6 which comprises a plurality of imaging units 7, 9, in this embodiment camera units, for imaging alignment features F, in this embodiment registration marks, often referred to as fiducials, on the upper surface of the workpiece W and the lower surface of the printing screen 5.

In this embodiment the workpiece support 3 includes a plurality of windows 15 through which respective ones of the imaging units 7, 9 of the imaging system 6 acquire images from the workpiece W and the printing screen 5.

In this embodiment the imaging system 6 comprises first and second workpiece imaging units 7a, 7b for imaging alignment features F on the upper surface of the workpiece W.

In this embodiment the first and second workpiece imaging units 7a, 7b are located at spaced positions so as to acquire images from alignment features F at spaced locations on the upper surface of the workpiece W, here at diagonally-opposite corners of the workpiece W.

Each workpiece imaging unit 7a, 7b comprises an illuminator 21, in this embodiment an infra-red (IR) light source, for illuminating a respective region of the lower surface of the workpiece W, the upper surface of which includes an alignment feature F, a camera 23 and associated optics 25 for acquiring an image of the illuminated alignment feature F.

In this embodiment the IR light source is a near infra-red (NIR) light source, which provides infra-red illumination at a wavelength of about 880 nm. In preferred embodiments the infra-red illumination has a wavelength in the range of about 760 nm to about 1000 nm.

The present inventors have recognized that it is possible to image an alignment feature F on an upper surface of a workpiece W from the lower surface of the workpiece W by using infra-red illumination. In a preferred embodiment the workpiece W is configured so as to include no artefacts on the lower surface thereof or within the body thereof which could mask the alignment features F to be imaged on the upper surface of the workpiece W.

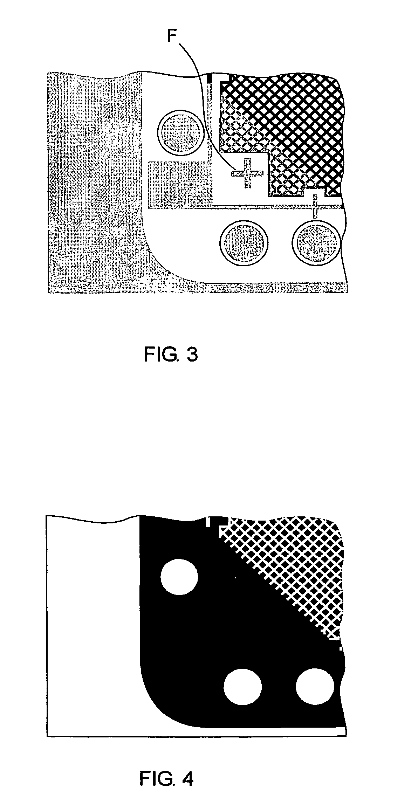

Figure 3 illustrates an image of the workpiece W as acquired from the lower surface of the workpiece W using one of the workpiece imaging units 7a, 7b, which clearly shows the alignment feature F on the upper surface of the workpiece W.

For comparison, Figure 4 illustrates the corresponding image of the workpiece W, where illuminated using visible light.

In this embodiment the imaging system 6 comprises first and second screen imaging units 9a, 9b for imaging alignment features F on the lower surface of the printing screen 5.

In this embodiment the first and second screen imaging units 9a, 9b are located at spaced positions so as to acquire images from alignment features F at spaced locations on the lower surface of the printing screen 5, here at opposite edges of the printing screen 5.

Each screen imaging unit 9a, 9b comprises an illuminator 31, in this embodiment a visible light source, for illuminating a respective region of the lower surface of the printing screen 5 which includes an alignment feature F, a camera 33 and associated optics 35 for acquiring an image of the illuminated alignment feature F.

With this configuration, alignment features F on the upper surface of the workpiece W and the lower surface of the printing screen 5 can be imaged without requiring the introduction of any components between the workpiece W and the printing screen 5. In this way, the spacing between the workpiece W and the printing screen 5 can be kept to a minimum, in this embodiment in the range of from about 2 mm to about 10 mm, typically about 5 mm, which reduces the time required to move the workpiece W and the printing screen 5 into the operative, printing configuration.

Following the acquisition of the images of the alignment features F on the workpiece W and the printing screen 5, the images are operated upon using an image processor 41, which utilizes known vision algorithms to calculate the required positional correction of the workpiece W and the printing screen 5, and this positional correction is performed using a positioner 43, under the control of a controller 45, typically a PC-controller.

In an alternative embodiment the imaging system 6 could comprise first and second imaging units 7a, 7b, which are operative to acquire images both of respective alignment features F on the upper surface of the workpiece W and the lower surface of the printing screen 5.

In one embodiment the imaging system 6 is configured to acquire images from the underside of the printing screen 5 prior to loading of a workpiece W, and subsequently images from a workpiece W following loading of the workpiece W. In this way, the alignment features F on the workpiece W and the printing screen 5 are acquired using a reduced number of imaging units 7a, 7b.

In another embodiment, where the alignment features F on the workpiece W and the printing screen 5 are sufficiently closely located, each imaging unit 7a, 7b simultaneously images alignment features on both the workpiece W and the printing screen 5. Again, this configuration allows for the use of a reduced number of imaging units 7a, 7b. This embodiment also advantageously only requires a single imaging step, as compared to separate steps for imaging the workpiece W and the printing screen 5. Finally, it will be understood that the present invention has been described in its preferred embodiment and can be modified in many different ways without departing from the scope of the invention as defined by the appended claims.

For example, in the described embodiment the alignment features F are registration marks on the workpiece W and the printing screen 5, but could be other physical features of the workpiece W or the printing screen 5, such as edges, which are identifiable in determining position.

## Claims

1. An imaging system for imaging at least one workpiece alignment feature (F) on an upper surface of a supported workpiece (W), the system comprising:
a workpiece support (3) which includes a support surface for supporting a workpiece (W); and
at least one imaging unit (7a, 7b) which is disposed below the support surface of the workpiece support (3) for imaging at least one workpiece alignment feature (F) on the upper surface of the workpiece (W), wherein the at least one imaging unit (7a, 7b) comprises an infra-red illuminator (21) which is operative to illuminate a region of a lower surface of the workpiece (W) and a detector (23) which is operative to capture an image of the region of the workpiece (W) which includes at least one workpiece alignment feature (F) on the upper surface of the workpiece (W), optionally the at least one imaging unit (7a, 7b) comprises a camera unit and the detector (23) comprises a camera.

2. The system of claim 1, wherein the infra-red illumination is near infra-red illumination, optionally at a wavelength in the range of about 760 nm to about 1000 nm, optionally at a wavelength of about 880 nm.

3. The system of claim 1 or 2, comprising:
first and second imaging units (7a, 7b) for imaging first and second workpiece alignment features (F) on the upper surface of the workpiece (W).

4. The system of any of claims 1 to 3, wherein the illuminator (21) of each imaging unit (7a, 7b) is operative to illuminate both a region of a lower surface of the workpiece (W) and a region of a lower surface of a printing screen (5) which is disposed above the workpiece support (3), and the detector (23) of each imaging unit (7a, 7b) is operative to capture both an image of the region of the workpiece (W) which includes at least one workpiece alignment feature (F) on the upper surface of the workpiece (W) and an image of the region of the printing screen (5) which includes at least one screen alignment feature (F).

5. The system of any of claims 1 to 3, wherein the illuminator (21) of each imaging unit (7a, 7b) is operative to illuminate a region of a lower surface of a printing screen (5) which is disposed above the workpiece support (3) when no workpiece (W) is supported on the workpiece support (3) and illuminate a region of a lower surface of the workpiece (W) when supported on the workpiece support (3), and the detector (23) of each imaging unit (7a, 7b) is operative to capture an image of the region of the printing screen (5) which includes at least one screen alignment feature (F) when no workpiece (W) is supported on the workpiece support (3) and capture an image of the region of the workpiece (W) which includes at least one workpiece alignment feature (F) on the upper surface of the workpiece (W) when supported on the workpiece support (3).

6. The system of any of claims 1 to 3, further comprising:
at least one further imaging unit (9a, 9b) for imaging at least one screen alignment feature (F) on a printing screen (5) which is disposed above the workpiece support (3), optionally first and second further imaging units (9a, 9b) for imaging first and second screen alignment features (F) on the printing screen (5), wherein the at least one further imaging unit (9a, 9b) comprises an illuminator (31) which is operative to illuminate a region of a lower surface of the printing screen (5) and a detector (33) which is operative to capture an image of the region of the printing screen (5) which includes at least one screen alignment feature (F).

7. A screen printing machine, comprising:
(i) the imaging system of any of claims 1 to 6; or
(ii) the imaging system of any of claims 3 to 6;
an image processor (41) for determining a required positional correction of the workpiece (W) and the printing screen (5) from the imaged alignment features (F); and
a positioner (43) for performing the required positional correction of the workpiece (W) and the printing screen (5).

8. A method of imaging at least one workpiece alignment feature (F) on an upper surface of a supported workpiece (W), the method comprising the steps of:
supporting a workpiece (W) on a support surface of a workpiece support (3); and
imaging at least one workpiece alignment feature (F) on the upper surface of the workpiece (W) from below the support surface of the workpiece support (3), wherein the imaging step comprises the steps of:
illuminating a region of a lower surface of the workpiece (W) with infra-red illumination; and
capturing an image of the region of the workpiece (W) which includes at least one workpiece alignment feature (F) on the upper surface of the workpiece (W).

9. The method of claim 8, wherein the infra-red illumination is near infra-red illumination, optionally having a wavelength in the range of about 760 nm to about 1000 nm, optionally having a wavelength of about 880 nm.

10. The method of claim 8 or 9, wherein, in the imaging step, first and second workpiece alignment features (F) are imaged on the upper surface of the workpiece (W), and the imaging step comprises the steps of:
illuminating first and second regions of a lower surface of the workpiece (W) with infra-red illumination; and
capturing first and second images of the regions of the workpiece (W) which include respective ones of first and second workpiece alignment features (F) on the upper surface of the workpiece (W).

11. The method of claim 8 or 9, wherein a printing screen (5) is disposed above the workpiece support (3) and at least one screen alignment feature (F) on the printing screen (5) is further imaged in the imaging step, and the imaging step comprises the steps of:
illuminating both a region of a lower surface of the workpiece (W) and a region of a lower surface of the printing screen (5) with an illuminator (21), wherein the lower surface of the workpiece (W) is illuminated with infra-red illumination; and
capturing both an image of the region of the workpiece (W) which includes at least one workpiece alignment feature (F) on the upper surface of the workpiece (W) and an image of the region of the printing screen (5) which includes at least one screen alignment feature (F) with a detector (23).

12. The method of claim 8 or 9, wherein a printing screen (5) is disposed above the workpiece support (3) and at least one screen alignment feature (F) on the printing screen (5) is further imaged in the imaging step, and the imaging step comprises the steps of:
illuminating a region of a lower surface of the printing screen (5) when no workpiece (W) is supported on the workpiece support (3);
capturing an image of the region of the printing screen (5) which includes at least one screen alignment feature (F);
supporting a workpiece (W) on the workpiece support (3);
illuminating a region of a lower surface of the workpiece (W) with infra-red illumination; and
capturing an image of the region of the workpiece (W) which includes at least one workpiece alignment feature (F).

13. The method of claim 8 or 9, wherein a printing screen (5) is disposed above the workpiece support (3) and, in the imaging step, first and second workpiece alignment features (F) are imaged on the upper surface of the workpiece (W) and first and second screen alignment features (F) are imaged on the printing screen (5), and the imaging step comprises the steps of:
illuminating first regions of a lower surface of the workpiece (W) and a lower surface of the printing screen (5) with a first illuminator (21),
and second regions of the lower surface of the workpiece (W) and the lower surface of the printing screen (5) with a second illuminator (21),
wherein the regions of the lower surface of the workpiece (W) are illuminated with infra-red illumination; and
capturing first images of the first region of the workpiece (W) which includes a first workpiece alignment feature (F) on the upper surface of the workpiece (W) and the first region of the printing screen (5) which includes a first screen alignment feature (F) using a first detector (23), and second images of the second region of the workpiece (W) which includes a second workpiece alignment feature (F) on the upper surface of the workpiece (W) and the second region of the printing screen (5) which includes a second screen alignment feature (F) using a second detector (23).

14. The method of claim 8 or 9, wherein a printing screen (5) is disposed above the workpiece support (3) and, in the imaging step, first and second workpiece alignment features (F) are imaged on the upper surface of the workpiece (W) and first and second screen alignment features (F) are imaged on a printing screen (5), and the imaging step comprises the steps of:
illuminating first and second regions of a lower surface of the workpiece (W) with respective ones of first and second illuminators (21), which are infra-red illuminators;
illuminating first and second regions of a lower surface of the printing screen (5) with respective ones of third and fourth illuminators (31);
capturing first and second images of the first and second regions of the workpiece (W) which include respective ones of first and second workpiece alignment features (F) on the upper surface of the workpiece (W) using respective ones of first and second detectors (23); and
capturing first and second images of the first and second regions of the printing screen (5) which include respective ones of first and
second screen alignment features (F) using respective ones of third and fourth detectors (33).

15. A method of screen printing on workpieces (W), the method comprising the steps of:
(i) imaging at least one workpiece alignment feature (F) on an upper surface of a supported workpiece (W) using the imaging method of any of claims 8 to 14; or
(ii) imaging at least one workpiece alignment feature (F) on an upper surface of a supported workpiece (W) and at least one screen alignment feature (F) on the printing screen (5) using the imaging method of any of claims 11 to 14;
determining a required positional correction of the workpiece (W) and the printing screen (5) from the imaged alignment features (F); and
performing the required positional correction of the workpiece (W) and the printing screen (5).

## Patentansprüche

1. Ein Abbildungssystem zum Abbilden mindestens eines Werkstückanordnungsmerkmals (F) auf einer Oberseite eines gelagerten Werkstückes (W), das System umfasst:
eine Werkstückauflage (3), die eine Auflagefläche zur Lagerung eines Werkstückes (W) beinhaltet; und
mindestens eine Abbildungseinheit (7a, 7b), die unter der Auflagefläche der Werkstückauflage (3) angebracht ist, zur Abbildung mindestens eines Werkzeuganordnungsmerkmals (F) auf der Oberseite des Werkstückes (W), wobei die mindestens eine Abbildungseinheit (7a, 7b) ein Infrarot-Beleuchtungsgerät (21), das in der Lage ist einen Bereich einer Unterseite des Werkstückes (W) zu beleuchten, und einen Detektor (23),
der in der Lage ist ein Bild des Bereiches des Werkstückes (W) aufzunehmen, der mindestens ein Werkstückanordnungsmerkmal (F) auf der Oberseite des Werkstückes (W) beinhaltet, wahlweise umfasst die mindestens eine Abbildungseinheit (7a, 7b) eine Kameraeinheit und der Detektor (23) umfasst eine Kamera.

2. Das System nach Anspruch 1, wobei die Infrarot-Beleuchtung Nah-Infrarot-Beleuchtung ist, wahlweise bei einer Wellenlänge im Bereich von ungefähr 760 nm bis ungefähr 1000 nm, wahlweise bei einer Wellenlänge von ungefähr 880 nm.

3. Das System nach Anspruch 1 oder 2, umfassend:
erste und zweite Abbildungseinheiten (7a, 7b) zur Abbildung erster und
zweiter Werkstückanordnungsmerkmale (F) auf der Oberseite des Werkstückes (W).

4. Das System nach einem der Ansprüche 1 bis 3, wobei das Beleuchtungsgerät (21) jeder Abbildungseinheit (7a, 7b) in der Lage ist sowohl einen Bereich einer Unterseite des Werkstückes (W) und einen Bereich einer Unterseite eines Druckrasters (5) zu beleuchten, das oberhalb der Werkstückauflage (3) angebracht ist, und der Detektor (23) jeder Abbildungseinheit (7a, 7b) in der Lage ist ein Bild sowohl von dem Bereich des Werkstückes (W), der mindestens ein Werkstückausrichtungsmerkmal (F) auf der Oberseite des Werkstückes (W) beinhaltet, als auch ein Bild von dem Bereich des Druckrasters (5) aufzunehmen, der mindestens ein Rasterausrichtungsmerkmal (F) beinhaltet.

5. Das System nach einem der Ansprüche 1 bis 3, wobei das Beleuchtungsgerät (21) jeder Abbildungseinheit (7a, 7b) in der Lage ist einen Bereich einer Unterseite eines Druckrasters (5) zu beleuchten, der oberhalb der Werkstückauflage (3) angebracht ist, wenn kein Werkstück (W) auf der Werkstückauflage (3) gelagert ist, und einen Bereich einer Unterseite des Werkstückes (W) zu beleuchten, wenn dies auf der Werkstückauflage (3) gelagert ist, und der Detektor (23) jeder Abbildungseinheit (7a, 7b) in der Lage ist ein Bild des Bereiches des Druckraster (5) aufzunehmen, der mindestens ein Rasterausrichtungsmerkmal (F) beinhaltet, wenn kein Werkstück (W) auf der Werkstückauflage (3) gelagert ist, und ein Bild von dem Bereich des Werkstückes (W) aufnimmt, der mindestens ein
Werkstückausrichtungsmerkmal (F) auf der Oberseite des Werkstückes (W) beinhaltet, wenn dies auf der Werkstückauflage (3) gelagert ist.

6. Das System nach einem der Ansprüche 1 bis 3, weiterhin umfassend:
mindestens eine weitere Abbildungseinheit (9a, 9b) zur Abbildung mindestens eines Rasterausrichtungsmerkmals (F) auf einem Druckraster (5), der oberhalb der Werkstückauflage (3) angebracht ist, wahlweise erste und zweite weitere Abbildungseinheiten (9a, 9b) zur Abbildung erster und zweiter Rasterausrichtungsmerkmale (F) auf dem Druckraster (5), wobei die mindestens eine weitere Abbildungseinheit (9a, 9b) eine Beleuchtungsanlage (31), die in der Lage ist einen Bereich einer Unterseite des Druckrasters (5) zu beleuchten, und einem Detektor (33) umfasst, der in der Lage ist ein Bild des Bereiches des Druckraster (5) aufzunehmen, der mindestens ein Rasterausrichtungsmerkmal (F) beinhaltet.

7. Eine Druckrastermaschine, umfassend:
(i) das Abbildungssystem nach einem der Ansprüche 1 bis 6; oder
(ii) das Abbildungssystem nach einem der Ansprüche 3 bis 6; einen Bildverarbeiter (41) zum Bestimmen einer erforderlichen Positionskorrektur des Werkstückes (W) und des Druckraster (5) aus den abgebildeten Ausrichtungsmerkmalen (F); und
einem Positionierer (43) zum Durchführen der erforderlichen Positionskorrektur des Werkstückes (W) und des Druckrasters (5).

8. Ein Verfahren zum Abbilden mindestens eines
Werkstückausrichtungsmerkmals (F) auf einer Oberseite eines gelagerten Werkstückes (W), das Verfahren umfasst die Schritte:
Lagern eines Werkstückes (W) auf einer Auflagefläche einer Werkstückauflage (3); und
Abbilden mindestens eines Werkstückausrichtungsmerkmals (F) auf der Oberseite des Werkstückes (W) von unterhalb der Auflagefläche der Werkstückauflage (3), wobei der Abbildungsschritt die Schritte umfasst:
Beleuchten eines Bereiches einer Unterseite des Werkstückes (W) mit Infrarot-Beleuchtung; und
Aufnehmen eines Bildes des Bereiches des Werkstückes (W), der mindestens ein Werkstückausrichtungsmerkmal (F) auf der Oberseite des Werkstückes (W) beinhaltet.

9. Verfahren nach Anspruch 8, wobei die Infrarot-Beleuchtung Nah-Infrarot-Beleuchtung ist, wahlweise eine Wellenlänge im Bereich von ungefähr 760 nm bis ungefähr 1000 nm habend, wahlweise eine Wellenlänge von ungefähr 880 nm habend.

10. Verfahren nach einem der Ansprüche 8 oder 9, wobei, in dem Abbildungsschritt, erste und zweite Werkstückausrichtungsmerkmale (F) auf der Oberseite des Werkstückes (W) abgebildet werden, und der Abbildungsschritt die Schritte umfasst:
Beleuchten erster und zweiter Bereiche der Unterseite des Werkstückes (W) mit Infrarot-Beleuchtung; und
Aufnehmen erster und zweiter Bilder der Bereiche des Werkstückes (W),
die jeweilige erste und zweite Werkstückausrichtungsmerkmale (F) auf der Oberseite des Werkstückes (W) beinhalten.

11. Verfahren nach einem der Ansprüche 8 oder 9, wobei ein Druckraster (5) oberhalb der Werkstückauflage (3) angebracht ist und ferner mindestens ein Rasterausrichtungsmerkmal (F) auf dem Druckraster (5) in dem Abbildungsschritt abgebildet wird, und der Abbildungsschritt die Schritte umfasst:
Beleuchten sowohl eines Bereiches einer Unterseite des Werkstückes (W) als auch eines Bereiches einer Unterseite des Druckrasters (5) mit einem Beleuchtungsgerät (21), wobei die Unterseite des Werkstückes (W) mit Infrarot-Beleuchtung beleuchtet wird; und
Aufnehmen mit einem Detektor (23) sowohl eines Bildes des Bereiches des Werkstückes (W), der mindestens ein
Werkstückausrichtungsmerkmal (F) auf der Oberseite des Werkstückes (W) beinhaltet, als auch eines Bildes des Bereiches des Druckrasters (5), der mindestens ein Rasterausrichtungsmerkmal (F) beinhaltet.

12. Verfahren nach Anspruch 8 oder 9, wobei ein Druckraster (5) oberhalb der Werkstückauflage (3) angebracht ist und ferner mindestens ein Rasterausrichtungsmerkmal (F) auf dem Druckraster (5) in dem Abbildungsschritt abgebildet wird, und der Abbildungsschritt die Schritte umfasst:
Beleuchten eines Bereiches einer Unterseite des Druckrasters (5) wenn kein Werkstück (W) in der Werkstückauflage (3) gelagert ist;
Aufnehmen eines Bildes des Bereiches des Druckrasters (5), der mindestens ein Rasterausrichtungsmerkmal (F) beinhaltet;
Lagern eines Werkstückes (W) auf der Werkstückauflage (3);
Beleuchten eines Bereiches auf einer Unterseite des Werkstückes mit Infrarot-Beleuchtung; und
Aufnehmen eines Bildes des Bereiches des Werkstückes (W), der mindestens ein Werkstückausrichtungsmerkmal (F) beinhaltet.

13. Verfahren nach Anspruch 8 oder 9, wobei ein Druckraster (5) oberhalb der Werkstückauflage (3) angebracht ist und, in dem Abbildungsschritt, erste und zweite Werkstückausrichtungsmerkmale (F) auf der Oberseite des Werkstückes (W) abgebildet werden und erste und zweite Rasterausrichtungsmerkmale (F) auf dem Druckraster (5) abgebildet werden, und der Abbildungsschritt die Schritt umfasst:
Beleuchten erster Bereiche einer Unterseite des Werkstückes (W) und
einer Unterseite des Druckrasters (5) mit einem ersten Beleuchtungsgerät (21), und zweiter Bereiche der Unterseite des Werkstückes (W) und der Unterseite des Druckrasters (5) mit einem zweiten Beleuchtungsgerät (21), wobei die Bereiche der Unterseite des Werkstückes mit Infrarot-Beleuchtung beleuchtet werden; und
Aufnehmen erster Bilder des ersten Bereiches des Werkstückes (W), der ein erstes Werkstückausrichtungsmerkmal (F) auf der Oberseite des Werkstückes (W) beinhaltet, und des ersten Bereiches des Druckrasters (5), der ein erstes Rasterausrichtungsmerkmal (F) beinhaltet, unter Verwendung eines ersten Detektors (23), und zweiter Bilder des zweiten Bereiches des Werkstückes (W), der ein zweites
Werkstückausrichtungsmerkmal (F) auf der Oberseite des Werkstückes (W) beinhaltet, und des zweiten Bereiches des Druckrasters (5), der ein zweites Rasterausrichtungsmerkmal (F) beinhaltet, unter Verwendung eines zweiten Detektors (23).

14. Verfahren nach Anspruch 8 oder 9, wobei ein Druckraster (5) oberhalb der Werkstückauflage (3) angebracht ist und, in dem Abbildungsschritt, erste und zweite Werkstückausrichtungsmerkmale (F) auf der Oberseite des Werkstückes abgebildet werden und erste und zweite Rasterausrichtungsmerkmale (F) auf einem Druckraster (5) abgebildet werden, und der Abbildungsschritt die Schritte umfasst:
Beleuchten erster und zweiter Bereiche einer Unterseite des Werkstückes (W) mit jeweiligen ersten und zweien Beleuchtungsgeräten (21), die Infrarot-Beleuchtungsgeräte sind;
Beleuchten erster und zweiter Bereiche einer Unterseite des Druckrasters (5) mit jeweiligen dritten und vierten Beleuchtungsgeräten (31);
Aufnehmen erster und zweiter Bilder der ersten und zweiten Bereiche des Werkstückes (W), die jeweilige erste und zweite
Werkstückausrichtungsmerkmale (F) auf der Oberseite des Werkstückes beinhalten, unter Verwendung jeweiliger erster und zweiter Detektoren (23); und
Aufnehmen erster und zweiter Bilder der ersten und zweiten Bereiche des Druckrasters (5), die jeweilige erste und zweite
Rasterausrichtungsmerkmale (F) beinhalten, unter Verwendung jeweiliger dritter und vierter Detektoren (33).

15. Verfahren zum Druckrastern auf Werkstücken (W), das Verfahren umfasst die Schritte:
(i) Abbilden mindestens eines Werkstückausrichtungsmerkmals (F) auf einer Oberseite eines gelagerten Werkstückes (W) unter Verwendung des Abbildungsverfahrens nach einem der Ansprüche 8 bis 14; oder
(ii) Abbilden mindestens eines Werkstückausrichtungsmerkmal (F) auf einer Oberseite eines gelagerten Werkstückes (W) und mindestens eines Rasterausrichtungsmerkmal (F) auf dem Druckraster (5) unter Verwendung des Abbildungsverfahrens nach einem der Ansprüche 11 bis 14;
Bestimmen einer erforderlichen Positionskorrektur des Werkstückes (W) und des Druckrasters (5) aus den abgebildeten Ausrichtungsmerkmalen (F); und
Durchführen der erforderlichen Positionskorrektur des Werkstückes (W) und des Druckrasters (5).

## Revendications

1. Système d'imagerie permettant d'imager au moins une particularité (F) d'alignement de pièce de fabrication sur une surface supérieure d'une pièce de fabrication (W) supportée, le système comprenant :
un support de pièce de fabrication (3) qui comprend une surface de support permettant de supporter une pièce de fabrication (W) ; et
au moins une unité d'imagerie (7a, 7b) qui est disposée en dessous de la surface de support du support de pièce de fabrication (3) permettant d'imager au moins une particularité (F) d'alignement de pièce de fabrication (F) sur la surface supérieure de la pièce de fabrication (W), dans lequel la au moins une unité d'imagerie (7a, 7b) comprend un illuminateur infrarouge (21) qui est opérationnel pour illuminer une région d'une surface inférieure de la pièce de fabrication (W) et un détecteur (23) qui est opérationnel pour capturer une image de la région de la pièce de fabrication (W) qui comprend au moins une particularité (F) d'alignement de pièce de fabrication sur la surface supérieure de la pièce de fabrication (W), facultativement la au moins une unité d'imagerie (7a, 7b) comprend une unité de caméra et le détecteur (23) comprend une caméra.

2. Système selon la revendication 1, dans lequel l'illumination infrarouge est une illumination proche infrarouge, facultativement à une longueur d'onde dans la plage d'environ 760 nm à environ 1 000 nm, facultativement à une longueur d'onde d'environ 880 nm.

3. Système selon la revendication 1 ou 2, comprenant :
des première et seconde unités d'imagerie (7a, 7b) permettant d'imager des première et seconde particularités (F) d'alignement de pièce de fabrication sur la surface supérieure de la pièce de fabrication (W).

4. Système selon l'une quelconque des revendications 1 à 3, dans lequel l'illuminateur (21) de chaque unité d'imagerie (7a, 7b) est opérationnel pour illuminer à la fois une région d'une surface inférieure de la pièce de fabrication (W) et une région d'une surface inférieure d'une trame d'impression (5) qui est disposée au-dessus du support de pièce de fabrication (3), et le détecteur (23) de chaque unité d'imagerie (7a, 7b) est opérationnel pour capturer à la fois une image de la région de la pièce de fabrication (W) qui comprend au moins une particularité (F) d'alignement de pièce de fabrication sur la surface supérieure de la pièce de fabrication (W) et une image de la région de la trame d'impression (5) qui comprend au moins une particularité (F) d'alignement de trame.

5. Système selon l'une quelconque des revendications 1 à 3, dans lequel l'illuminateur (21) de chaque unité d'imagerie (7a, 7b) est opérationnel pour illuminer une région d'une surface inférieure d'une trame d'impression (5) qui est disposée au-dessus du support de pièce de fabrication (3) lorsqu'aucune pièce de fabrication (W) n'est supportée sur le support de pièce de fabrication (3) et illuminer une région d'une surface inférieure de la pièce de fabrication (W) lorsque celle-ci est supportée sur le support de pièce de fabrication (3), et le détecteur (23) de chaque unité d'imagerie (7a, 7b) est opérationnel pour capturer une image de la région de la trame d'impression (5) qui comprend au moins une particularité (F) d'alignement de trame lorsqu'aucune pièce de fabrication (W) n'est supportée sur le support de pièce de fabrication (3) et pour capturer une image de la région de la pièce de fabrication (W) qui comprend au moins une particularité (F) d'alignement de pièce de fabrication sur la surface supérieure de la pièce de fabrication (W) lorsque celle-ci est supportée sur le support de pièce de fabrication (3).

6. Système selon l'une quelconque des revendications 1 à 3, comprenant en outre :
au moins une unité d'imagerie supplémentaire (9a, 9b) permettant d'imager au moins une particularité (F) d'alignement de trame sur une trame d'impression (5) qui est disposée au-dessus du support de pièce de fabrication (3), facultativement des première et seconde unités d'imagerie supplémentaires (9a, 9b) permettant d'imager des première et seconde particularités (F) d'alignement de trame sur la trame d'impression (5), dans lequel la au moins une unité d'imagerie supplémentaire (9a, 9b) comprend un illuminateur (31) qui est opérationnel pour illuminer une région d'une surface inférieure de la trame d'impression (5), et un détecteur (33) qui est opérationnel pour capturer une image de la région de la trame d'impression (5) qui comprend au moins une particularité (F) d'alignement de trame.

7. Machine de sérigraphie comprenant :
(i) le système d'imagerie selon l'une quelconque des revendications 1 à 6 ; ou
(ii) le système d'imagerie selon l'une quelconque des revendications 3 à 6 ;
un processeur d'image (41) permettant de déterminer une correction de positionnement requise de la pièce de fabrication (W) et de la trame d'impression (5) d'après les particularités (F) d'alignement imagées ; et
un positionneur (43) permettant de réaliser la correction de positionnement requise de la pièce de fabrication (W) et de la trame d'impression (5).

8. Procédé permettant d'imager au moins une particularité (F) d'alignement de pièce de fabrication sur une surface supérieure d'une pièce de fabrication (W) supportée, le procédé comprenant les étapes consistant à :
supporter une pièce de fabrication (W) sur une surface de support d'un support de pièce de fabrication (3) ; et
imager au moins une particularité (F) d'alignement de pièce de fabrication sur la surface supérieure de la pièce de fabrication (W) de dessous la surface de support du support de la pièce de fabrication (3), où l'étape d'imagerie comprend les sous-étapes consistant à :
illuminer une région d'une surface inférieure de la pièce de fabrication (W) avec une illumination infrarouge ; et
capturer une image de la région de la pièce de fabrication (W) qui comprend au moins une particularité (F) d'alignement de pièce de fabrication sur la surface supérieure de la pièce de fabrication (W).

9. Procédé selon la revendication 8, dans lequel l'illumination infrarouge est une illumination proche infrarouge, facultativement ayant une longueur d'onde dans la plage d'environ 760 nm à environ 1 000 nm, facultativement ayant une longueur d'onde d'environ 880 nm.

10. Procédé selon la revendication 8 ou 9, dans lequel, dans l'étape d'imagerie, des première et seconde particularités (F) d'alignement de pièce de fabrication sont imagées sur la surface supérieure de la pièce de fabrication (W), et l'étape d'imagerie comprend les sous-étapes consistant à :
illuminer des première et seconde régions d'une surface inférieure de la pièce de fabrication (W) avec une illumination infrarouge ; et
capturer des première et seconde images des régions de la pièce de fabrication (W) qui comprennent des particularités respectives des première et seconde particularités (F) d'alignement de pièce de fabrication sur la surface supérieure de la pièce de fabrication (W).

11. Procédé selon la revendication 8 ou 9, dans lequel une trame d'impression (5) est disposée au-dessus du support de pièce de fabrication (3) et au moins une particularité (F) d'alignement de trame sur la trame d'impression (5) est en outre imagée dans l'étape d'imagerie, et l'étape d'imagerie comprend les sous-étapes consistant à :
illuminer à la fois une région d'une surface inférieure de la pièce de fabrication (W) et une région d'une surface inférieure d'une trame d'impression (5) avec un illuminateur (21), où la surface inférieure de la pièce de fabrication (W) est illuminée par une illumination infrarouge ; et
capturer à la fois une image de la région de la pièce de fabrication (W) qui comprend au moins une particularité (F) d'alignement de pièce de fabrication sur la surface supérieure de la pièce de fabrication (W) et une image de la région de la trame d'impression (5) qui comprend au moins une particularité (F) d'alignement de trame avec un détecteur (23).

12. Procédé selon la revendication 8 ou 9, dans lequel une trame d'impression (5) est disposée au-dessus du support de pièce de fabrication (3) et au moins une particularité (F) d'alignement de trame sur la trame d'impression (5) est en outre imagée à l'étape d'imagerie, et l'étape d'imagerie comprend les sous-étapes consistant à :
illuminer une région d'une surface inférieure de la trame d'impression (5) lorsqu'aucune pièce de fabrication (W) n'est supportée sur le support de pièce de fabrication (3) ;
capturer une image de la région de la trame d'impression (5) qui comprend au moins une particularité (F) d'alignement de trame ;
supporter une pièce de fabrication (W) sur le support de pièce de fabrication (3) ;
illuminer une région d'une surface inférieure de la pièce de fabrication (W) par une illumination infrarouge ; et
capturer une image de la région de la pièce de fabrication (W) qui comprend au moins une particularité (F) d'alignement de pièce de fabrication.

13. Procédé selon la revendication 8 ou 9, dans lequel une trame d'impression (5) est disposée au-dessus du support de pièce de fabrication (3) et, dans l'étape d'imagerie, des première et seconde particularités (F) d'alignement de pièce de fabrication sont imagées sur la surface supérieure de la pièce de fabrication (W) et des première et seconde particularités (F) d'alignement de trame sont imagées sur la trame d'impression (5), et l'étape d'imagerie comprend les sous-étapes consistant à :
illuminer des premières régions d'une surface inférieure de la pièce de fabrication (W) et une surface inférieure de la trame d'impression (5) avec un premier illuminateur (21), et des secondes régions de la surface inférieure de la pièce de fabrication (W) et la surface inférieure de la trame d'impression (5) avec un deuxième illuminateur (21), où les régions de la surface inférieure de la pièce de fabrication (W) sont illuminées par une illumination infrarouge ; et
capturer des premières images de la première région de la pièce de fabrication (W) qui comprend une première particularité (F) d'alignement de pièce de fabrication sur la surface supérieure de la pièce de fabrication (W) et la première région de la trame d'impression (5) qui comprend une première particularité (F) d'alignement de trame à l'aide d'un premier détecteur (23), et des secondes images de la seconde région de la pièce de fabrication (W) qui
comprend une seconde particularité (F) d'alignement de pièce de fabrication sur la surface supérieure de la pièce de fabrication (W) et la seconde région de la trame d'impression (5) qui comprend une seconde particularité (F) d'alignement de trame à l'aide d'un second détecteur (23).

14. Procédé selon la revendication 8 ou 9, dans lequel une trame d'impression (5) est disposée au-dessus du support de pièce de fabrication (3) et, dans l'étape d'imagerie, des première et seconde particularités (F) d'alignement de pièce de fabrication sont imagées sur la surface supérieure de la pièce de fabrication (W) et des première et seconde particularités (F) d'alignement de trame sont imagées sur une trame d'impression (5), et l'étape d'imagerie comprend les sous-étapes consistant à :
illuminer des premières et secondes régions d'une surface inférieure de la pièce de fabrication (W) avec des illuminateurs respectifs des premier et deuxième illuminateurs (21), qui sont des illuminateurs infrarouges ;
illuminer des premières et secondes régions d'une surface inférieure de la trame d'impression (5) avec des illuminateurs respectifs des troisième et quatrième illuminateurs (31) ;
capturer des premières et secondes images des première et seconde régions de la pièce de fabrication (W) qui comprennent des particularités respectives des première et seconde particularités (F) d'alignement de pièce de fabrication sur la surface supérieure de la pièce de fabrication (W) à l'aide des détecteurs respectifs des premier et second détecteurs (23) ; et
capturer des premières et secondes images des premières et secondes régions de la trame d'impression (5) qui comprennent des particularités respectives des première et seconde particularités (F) d'alignement de trame à l'aide des détecteurs respectifs des troisième et quatrième détecteurs (33).

15. Procédé de sérigraphie sur des pièces de fabrication (W), le procédé comprenant les étapes consistant à :
(i) imager au moins une particularité (F) d'alignement de pièce de fabrication sur une surface supérieure d'une pièce de fabrication (W) supportée à l'aide du procédé d'imagerie de l'une quelconque des revendications 8 à 14 ; ou
(ii) imager au moins une particularité (F) d'alignement de pièce de fabrication sur une surface supérieure d'une pièce de fabrication (W) supportée et au moins une particularité (F) d'alignement de trame de
la trame d'impression (5) à l'aide du procédé d'imagerie de l'une quelconque des revendications 11 à 14 ;
déterminer une correction de positionnement requise de la pièce de fabrication (W) et de la trame d'impression (5) d'après les particularités (F) d'alignement imagées ; et
réaliser la correction de positionnement requise de la pièce de fabrication (W) et de la trame d'impression(5).
